# EUROPÄISCHE PATENTSCHRIFT

(11) **EP 0 196 474 B1**
(45) Veröffentlichungstag und Bekanntmachung des Hinweises auf die Patenterteilung: **06.08.1997**
(21) Anmeldenummer: 86102757.1
(22) Anmeldetag: 03.03.1986
(51) Int. Cl.: H01L 29/207, H01L 21/205, H01L 21/208

(54) **Halbleiteranordnung aus Verbindungshalbleitermaterial**
Semiconductor device made of compound semiconductor material
Dispositif semi-conducteur constitué de matériau semi-conducteur composé

(30) Priorität: 07.03.1985 DE 3508024
(43) Veröffentlichungstag der Anmeldung: 08.10.1986
(73) Patentinhaber: TEMIC TELEFUNKEN microelectronic GmbH, 74072 Heilbronn (DE)
(72) Erfinder: Beneking, Heinz, Prof. Dr. rer. nat., D-5100 Aachen (DE)
(74) Vertreter: Maute, Hans-Jürgen, Dipl.-Ing.

(56) Entgegenhaltungen:
- DE-A- 1 803 731
- JOURNAL OF CRYSTAL GROWTH, Band 61, 1983, Seiten 417-424, North-Holland Publishing Co.; G. JACOB et al.: "Dislocation-free GaAs and inP crystals by isoelectronic doping"
- APPLIED PHYSICS LETTERS, Band 46, Nr. 7, 1. April 1985, Seiten 668-670, American Institute of Physics, Woodbury, New York, US; H. EHRENREICH et al.: "Mechanism for dislocation density reduction in GaAs crystals by indium addition

## Beschreibung

Die Erfindung betrifft ein Verfahren zum Herstellen einer Halbleiteranordnung aus Verbindungs-Halbleitermaterial wie sie aus der DE-OS 18 03 731 und der Literaturstelle "Journal of Crystal Growth" 61 (1983), Seiten 417 - 424 bekannt ist.

Beim Herstellen elektronischer Bauelemente wird vielfach Verbindungs-Halbleitermaterial verwendet. Die gebräuchlichsten Verbindungs-Halbleitermaterialien bestehen aus Stoffen der III. und V. Gruppe des Periodensystems der Elemente, insbesondere aus Gallium-Arsenid oder Indium-Phosphid. Vielfach werden auch Mehrfachverbindungen, beispielsweise aus GaAlAs, GalnAs oder GalnAsP verwendet. Auf der Basis solcher Halbleitermaterialien werden insbesondere optoelektronische Bauelemente, Halbleiter-Laser, Bauelemente mit Schottky-Übergängen und integrierte Halbleiterschaltungen gefertigt. Bei der Herstellung der genannten Bauelemente wird von einem Grundkörper ausgegangen, der auf verschiedene Weise, beispielsweise durch Zonenschmelzen, durch das horizontale Bridgman-Verfahren oder durch das LEC-Verfahren (Liquid Encapsulated Czochralski) hergestellt werden kann. Auf diesen Grundkörper werden eine oder mehrere Halbleiterschichten - vorzugsweise durch epitaktisches Abscheiden - aufgebracht.

Für die Qualität dieser Epitaxie-Halbleiterschichten, die mittels Flüssigphasenepitaxie-Verfahren oder Dampfphasenepltaxie-Verfahren abgeschieden werden können, ist die Versetzungsdichte im Grundkörper entscheidend. Für jede weitere aufwachsende Epitaxie-Halbleiterschicht ist es von wesentlicher Bedeutung, wie groß die Versetzungsdichte in den darunterliegenden Epitaxie-Halbleiterschichten ist. In der Literatur werden Versetzungsdichten von 10⁴ bis 10⁵/cm² als relativ niedrig angegeben. Für die Herstellung hochqualitativer Bauelemente sind die genannten Werte für die Versetzungsdichte jedoch viel zu groß. Beispielsweise zur Herstellung von Feldeffekttransistoren werden in die Grundkörper mit den genannten Versetzungsdichten durch Implantationen von Störstellen bestimmte Strukturen eingebaut. Die elektrischen Kennwerte dieser Feldeffekttransistoren werden durch die erwähnte hohe Versetzungsdichte im Grundkörper erheblich verschlechtert.

Auch beim Aufbau von Mehrschichtstrukturen mit Hetero-Übergängen bewirken die sich in die Epitaxie-Halbleiterschichten fortsetzenden Versetzungen gravierende Störungen. Bei diesen Bauelementen werden auf einem Grundkörper Halbleiterschichten abgeschieden, die nicht den exakt gleichen Gitterabstand untereinander und zum Grundkörper aufweisen. Der Grundkörper besteht vielfach aus einem Zweifach-Verbindungs-Halbleitermaterial wie Gallium-Arsenid oder Indium-Phosphid, auf den Schichten aus ternärem oder quaternärem Halbleitermaterial, wie beispielsweise GaAlAs oder GalnAsP, abgeschieden werden. Da die Gitterabstände der Halbleitermaterialien der verschiedenen Halbleiterschichten nicht exakt miteinander übereinstimmen, aber ein einkristallines Aufwachsen gefordert wird, ist es leicht verständlich, daß sich hierbei eine hohe Versetzungsdichte im Grundkörper sehr störend auswirkt. In den genannten Epitaxie-Halbleiterschichten entstehen dann eine Vielzahl von Rekombinationszentren, durch die sich die Lebensdauer der Ladungsträger sehr stark verringert. Die Kennlinien der übergänge zwischen verschiedenen Halbleiterschichten bzw. zwischen dem Grundkörper und der darauf angeordneten Halbleiterschicht wird durch die hohe Versetzungsdichte gegenüber den ldealwerten wesentlich verschlechtert. Bei Lichtemittern bewirkt eine hohe Versetzungsdichte eine schlechte Lumineszenzausbeute, woraus sich ein geringer Wirkungsgrad von Leuchtdioden und Laseranordnungen ergibt.

In der gattungsbildenden DE-OS 18 03 731 wird ein Verfahren zum Kristallisieren einer binären Halbleitervorrichtung beschrieben, bei dem in eine Schmelzlösung für die Kristallzucht eines binären Verbindungs-Halbleiterkristalls isoelektronische Elemente eingefügt werden. Diese Hinzugabe von isoelektronischen Elementen in die Schmelzlösung, beispielsweise von Indium in eine Gallium-Arsenid-Schmelzlösung, dient zur Homogenisierung der Schmelzlösung; die isoelektronischen Elemente sollen daher in der Schmelzlösung verbleiben und nicht in den mittels der Schmelzlösung gebildeten Verbindungs-Halbleiterkristall eingebaut werden.

Aus der eingangs genannten Literaturstelle "Journal of Crystal Growth" 61 (1983), Seiten 417 - 424 ist es bekannt, beim Wachstum von Einkristallen aus Verbindungs-Halbleitermaterial die Schmelze mit isoelektronischem Störstellenmaterial zu dotieren, um die Materialgüte der Kristalle zu verbessern, insbesondere um die Versetzungsdichte in den Kristallen (Grundkörpern) zu reduzieren.

Der Erfindung liegt die Aufgabe zugrunde, ein Verfahren zum Herstellen einer Halbleiteranordnung aus Verbindungs-Halbleitermaterial anzugeben, mit dem eine mehrschichtige Halbleiteranordnung mit verbesserten Eigenschaften, insbesondere bezüglich der Versetzungsdichte, erhalten wird. Diese Aufgabe wird erfindungsgemäß durch die Merkmale des Patentanspruchs 1 gelöst.

Durch den erfindungsgemäßen Einbau von Verspannungszentren in mindestens eine auf den Grundkörper epitaktisch aufgewachsene Halbleiterschicht wird eine Fixierung und damit Beendigung des weiteren Wachstums von Versetzungen in den Epitaxie-Halbleiterschichten während deren Herstellung erreicht. Diese Verspannungszentren sollen keine zusätzliche, unerwünschte Dotierung bewirken, was durch die Verwendung isoelektronischen Störstellenmaterials erreicht wird. Hierdurch wird im Regelfalle außerdem der Einbau von Störatomen, die nicht der III. bzw. V. Gruppe des Periodensystems der Elemente angehören, erschwert. Bei der mehrschichtigen Halbleiteranordnung kann es ausreichend sein, das isoelektronische Störstellenmaterial nur in eine erste Halbleiterschicht einzubringen, die damit eine sehr geringe Versetzungsdichte von ca. 10³ cm⁻² und kleiner hat.
Wenn das Verbindungs-Halbleitermaterial beispielsweise Indium-Phosphid ist, eignet sich als isoelektronisches Störstellenmaterial Arsen, Antimon oder Wismut. Zum Indium ist Aluminium und Gallium isoelektronisch, doch haben beide Atome einen kleineren Atomradius als Indium und scheiden somit für eine Kompensation der Versetzungen aus. Im Gegensatz dazu weisen die zu Phosphor isoelektronischen Störstellenmaterialien Arsen, Antimon und Wismut einen größeren Atomradius als Phosphor auf, so daß mit diesen Elementen eine wirksame Kompensation der Versetzungen erreicht werden kann. Bei Gallium-Arsenid oder Gallium-Phosphid wird durch Zugabe von Störstellen der III. Gruppe des Periodensystems der Elemente, insbesondere von Indium, eine erhebliche Reduzierung der Versetzungsdichte erreicht, was wiederum darauf zurückzuführen ist, daß Indium einen größeren Atomradius als das zum Indium isoelektronische Gallium aufweist.

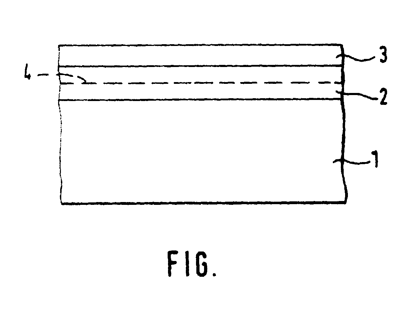

Bei der Anordnung nach der Figur wird von einem Grundkörper 1 ausgegangen, der beispielsweise aus Indium-Phosphid besteht und kein isoelektronisches Störstellenmaterial enthält. Die Versetzungsdichte in diesem Grundkörper 1 liegt bei 10⁴ - 10⁵ cm⁻². Auf diesen Grundkörper 1 wird sodann eine Epitaxieschicht als Halbleiterschicht 2 aufgebracht, die mindestens 1 µm dick ist und isoelektronisches Störstellenmaterial enthält. Die Halbleiterschicht 2 kann auch aus ternärem oder quaternärem Material wie GalnAs oder GalnAsP bestehen. In diesem Fall ist Antimon bzw. Wismut als isoelektronisches Störstellenmaterial geeignet. Das isoelektronische Störstellenmaterial bewirkt eine geringfügige Änderung der Gitterkonstanten, die kleiner als 10⁻⁴ ist. Normalerweise ist diese geringfügige Änderung der Gitterkonstanten nicht störend für das weitere Aufwachsen von Epitaxie-Halbleiterschichten. Wenn jedoch - wie dies bei Hetero-Übergängen der Fall ist - die Gitterkonstante des Grundkörpers 1 von der aufzuwachsenden Epitaxieschicht (Halbleiterschicht 2) abweicht, empfiehlt es sich, dem Halbleitermaterial der Halbleiterschicht 2 das isoelektronische Störstellenmaterial so zuzusetzen, daß dessen Konzentration mit dem Wachstum der Halbleiterschicht 2, also in Aufwachsrichtung, zunimmt. Dies kann dadurch geschehen, daß bei Flüssigphasenepitaxie-Verfahren die Konzentration des isoelektronischen Störstellenmaterials in der Schmelze kontinuierlich erhöht wird.
Wenn auf die Halbleiterschicht 2 eine weitere Halbleiterschicht 3 als Epitaxieschicht aufgebracht werden soll, deren Halbleitermaterial und damit Gitterkonstante sich von der der Halbleiterschicht 2 unterscheidet, empfiehlt es sich, dem Halbleitermaterial für die Halbleiterschicht 2 das isoelektronische Störstellenmaterial so zuzusetzen, daß dessen Konzentration mit dem Wachstum der Halbleiterschicht 2 zunächst bis zu einem Maximum zunimmt und danach wieder abnimmt. Das Maximum der Störstellenkonzentration des isoelektronischen Störstellenmaterials ist in der Figur durch die Linie 4 angedeutet. Auf diese Weise wird erreicht, daß die Halbleiterschicht 2 an den übergängen zum Grundkörper 1 und zur Halbleiterschicht 3 keine zusätzliche, durch das isoelektronische Störstellenmaterial bedingte Veränderung der Gitterkonstanten aufweist, die Versetzungsdichte jedoch erheblich reduziert wurde. Die aufwachsende Halbleiterschicht 3 wird daher gleichfalls eine geringe Versetzungsdichte aufweisen, auch wenn in diese Halbleiterschicht 3 selbst kein isoelektronisches Störstellenmaterial eingefügt wurde. Bei der Herstellung der Halbleiterschicht 2 mittels Flüssigphasenepitaxie-Verfahren mit einem Maximum der Störstellenkonzentration des isoelektronischen Störstellenmaterials wird man den Antell des isoelektronischen Störstellenmaterials in der Schmelze zunächst kontinuierlich während des Aufwachsprozesses erhöhen. Nach Erreichen des Maximums wird man die Konzentration des isoelektronischen Störstellen materials beispielsweise dadurch reduzieren, daß der Anteil der anderen Bestandteile in der Schmelze kontinuierlich erhöht wird. Entsprechend kann man bei der Herstellung der Halbleiterschichten mittels Gasphasenepitaxie-Verfahren vorgehen, wobei dann die isoelektronische Dotierung durch Zufuhr entsprechender gasförmiger Komponenten erfolgt.

Der Anteil des isoelektronischen Störstellen materials beträgt vorzugsweise weniger als 0,5 % des Elementes, zu dem das Störstellenmaterial isoelektronisch ist. In experimentellen Versuchen hat sich gezeigt, daß Werte zwischen 0,1 % und 0,3 % völlig ausreichend sind.

Das erfindungsgemäße Verfahren ist insbesondere zur Herstellung von optoelektronischen Bauelementen, Laseranordungen, Speicherbauelementen, integrierten Schaltkreisen und Bauelementen mit Schottky-Kontakten geeignet.

## Patentansprüche

1. Verfahren zum Herstellen einer Halbleiteranordnung aus VerbindungsHalbleitermaterial, das isoelektronisches Störstellenmaterlal aus einem Element enthält, dessen Atomradius größer ist als der kovalente Atomradius des Elements des Verbindungs-Halbleitermaterials, zu dem das Störstellenmaterial isoelektronisch ist, dadurch gekennzeichnet, daß
- auf einen Grundkörper (1) der kein isoelektronisches Störstellenmaterial enthält, nacheinander mehrere Halbleiterschichten (2, 3) aus unterschiedlichem Verbindungs-Halbleitermaterial zur Bildung von Hetero-Übergängen epitaktisch abgeschieden werden,
- und beim Abscheidevorgang mindestens einer der Halbleiterschichten (2,3) das isoelektronische Störstellenmaterial derart zugesetzt wird, daß zur Reduzierung der Versetzungsdichte die konzentration des isoelektronischen Störstellenmaterials ausgehend von einem Hetero-Übergang, bei dem Verbindungs-Halbleitermaterialien mit unterschiedlichen Gitterkonstanten aneinandergrenzen, in Richtung auf das Innere der abzuscheidenden Halbleiterschicht zunimmt.

2. Verfahren nach Anspruch 1, dadurch gekennzeichnet, daß die Konzentration des isoelektronischen Störstellenmaterials in der Halbleiterschicht (2) im Verlauf des Schichtwachstums der Halbleiterschicht (2) bis zu einem Maximum (4) zunimmt und danach wieder abnimmt.

3. Verfahren nach Anspruch 1 oder 2, dadurch gekennzeichnet, daß bei einem Verbindungs-Halbleitermaterial aus Aluminium-Phosphid, Indium-Phosphid oder Gallium-Phosphid isoelektronisches Störstellenmaterial aus Elementen der V. Gruppe des Periodensystems der Elemente mit einem Atomradius größer als der von Phosphor verwendet wird.

4. Verfahren nach Anspruch 3, dadurch gekennzeichnet, daß bei mindestens einer Halbleiterschicht (2, 3) aus Indium-Phosphid isoelektronisches Störstellenmaterial aus Arsen in einer Konzentration von mehr als 5 • 10¹⁸ Atome/ cm³ eingebracht worden ist.

5. Verfahren nach Anspruch 1 oder 2, dadurch gekennzeichnet, daß bei einem Verbindungs-Halbleitermaterial aus Gallium-Arsenid oder Gallium-Phosphid isoelektronisches Störstellenmaterial aus Elementen der III. Gruppe des Periodensystems der Elemente mit einem Atomradius größer als der von Gallium verwendet wird.

6. Verfahren nach Anspruch 1 oder 2, dadurch gekennzeichnet, daß bei einer auf einem Grundkörper (1) aus Indium-Phosphid epitaktisch abgeschiedenen Halbleiterschicht (2, 3) aus GalnAs oder GalnAsP isoelektronisches Störstellenmaterial aus Antimon oder Wismut verwendet wird.

## Claims

1. Method of manufacturing a semiconductor device consisting of a compound semiconductor material which includes an iso-electronic impurity material that consists of an element whose atomic radius is larger than the covalent atomic radius of the element in the compound semiconductor material relative to which the impurity material is iso-electronic, characterised in that,
- a plurality of semiconductor layers (2, 3) consisting of different compound semiconductor materials are successively deposited epitaxially for forming hetero-junctions on a substrate (1) that does not include any iso-electronic impurity material,
- and, for the purposes of reducing the dislocation density, the iso-electronic impurity material is added to at least one of the semiconductor layers (2, 3) during the deposition process in such a manner that, commencing from one hetero-junction at which compound semiconductor materials having different lattice constants border upon one another, the concentration of the iso-electronic impurity material increases towards the interior of the semiconductor layer that is being deposited.

2. Method in accordance with Claim 1, characterised in that, the concentration of the iso-electronic impurity material in the semiconductor layer (2) increases up to a maximum (4) during the process of growing the layer of the semiconductor layer (2) and thereafter decreases.

3. Method in accordance with Claim 1 or 2, characterised in that, an iso-electronic impurity material consisting of elements from the V^{th} Group of elements of the Periodic Table having an atomic radius that is larger than that of phosphorus is used in the case of a compound semiconductor material consisting of aluminium phosphide, indium phosphide or gallium phosphide.

4. Method in accordance with Claim 3, characterised in that, an iso-electronic impurity material consisting of arsenic having a concentration of more than 5 ∗ 10¹⁸ atoms/cm³ has been introduced in the case of at least one semiconductor layer (2, 3) consisting of indium phosphide.

5. Method in accordance with Claim 1 or 2, characterised in that, an iso-electronic impurity material consisting of elements from the III^{rd} Group of elements of the Periodic Table having an atomic radius that is larger than that of gallium is used in the case of a compound semiconductor material consisting of gallium arsenide or gallium phosphide.

6. Method in accordance with Claim 1 or 2, characterised in that, an iso-electronic impurity material consisting of antimony or bismuth is used in the case of a semiconductor layer (2, 3) of GaInAs or GaInAsP that is epitaxially deposited on a substrate (1) consisting of indium phosphide.

## Revendications

1. Procédé pour fabriquer un dispositif semi-conducteur constitué de matériau semi-conducteur composé qui contient du matériau à impuretés isoélectronique d'un élément dont le rayon atomique est plus grand que le rayon atomique covalent de l'élément du matériau semi-conducteur composé par rapport auquel le matériau à impuretés est isoélectronique, caractérisé en ce que
- sur un substrat (1) qui ne contient pas de matériau à impuretés isoélectronique, on dépose successivement, par épitaxie, plusieurs couches à semi-conducteurs (2, 3), constituées de différents matériaux à semi-conducteurs composés, en vue de la formation d'hétérojonctions et
- pendant le processus de dépôt d'au moins l'une des couches à semi-conducteurs (2, 3), on ajoute en mélange le matériau à impuretés isoélectronique de manière que, afin de réduire la densité des dislocations, la concentration du matériau à impuretés isoélectronique augmente à partir d'une hétérojonction à laquelle des matériaux à semi-conducteurs composés ayant des constantes réticulaires différentes sont limitrophes, en direction de l'intérieur de la couche à semi-conducteur à déposer.

2. Procédé selon la revendication 1, caractérisé en ce que la concentration du matériau à impuretés isoélectronique dans la couche à semi-conducteur (2) augmente jusqu'à un maximum (4) au cours de la croissance de la couche à semi-conducteur (2) et diminue de nouveau ensuite.

3. Procédé selon la revendication 1 ou 2, caractérisé en ce que, dans le cas d'un matériau à semi-conducteur composé en phosphure d'aluminium, phosphure d'indium ou phosphure de gallium, on utilise du matériau à impuretés isoélectronique d'éléments du groupe V du système périodique des éléments ayant un rayon atomique plus grand que celui du phosphore.

4. Procédé selon la revendication 3, caractérisé en ce que, au cas où au moins une couche à semi-conducteur (2, 3) est en phosphure d'indium, du matériau à impuretés isoélectronique d'arsénic a été introduit dans une concentration supérieure à 5 · 10¹⁸ atomes/cm³.

5. Procédé selon la revendication 1 ou 2, caractérisé en ce que, dans le cas d'un matériau à semi-conducteur composé d'arséniure de gallium ou de phosphure de gallium, on utilise du matériau à impuretés isoélectronique d'éléments du groupe III du système périodique des éléments avec un rayon atomique supérieur à celui de gallium.

6. Procédé selon la revendication 1 ou 2, caractérise en ce que, dans le cas d'une couche à semi-conducteur (2, 3) en GalnAs ou GalnAsP déposée par épitaxie sur un substrat (1) en phosphure d'indium, on utilise du matériau à impuretés isoélectronique d'antimoine ou de bismuth.
